(19) Europäisches Patentamt
European Patent Office
Office européen des brevets

(11) **EP 3 149 504 B1**

(12) **FASCICULE DE BREVET EUROPEEN**

(45) Date de publication et mention
de la délivrance du brevet:
**29.08.2018 Bulletin 2018/35**

(51) Int Cl.:
***G01R 33/035*** *(2006.01)*   ***G01R 33/00*** *(2006.01)*

(21) Numéro de dépôt: **15725626.4**

(22) Date de dépôt: **29.05.2015**

(86) Numéro de dépôt international:
**PCT/EP2015/062039**

(87) Numéro de publication internationale:
**WO 2015/181381 (03.12.2015 Gazette 2015/48)**

(54) **CAPTEUR MAGNÉTOMÉTRIQUE**

MAGNETOMETRISCHER SENSOR

MAGNETOMETRIC SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.05.2014 FR 1401252**

(43) Date de publication de la demande:
**05.04.2017 Bulletin 2017/14**

(73) Titulaire: **THALES**
**92400 Courbevoie (FR)**

(72) Inventeurs:
• **DESURVIRE, Emmanuel**
**F-91767 Palaiseau (FR)**
• **CASTERA, Jean-Paul**
**F-91767 Palaiseau (FR)**
• **DEMOTES-MAINARD, Bertrand**
**F-92526 Neuilly Sur Seine Cedex (FR)**

(74) Mandataire: **Lavoix**
**2, place d'Estienne d'Orves**
**75441 Paris Cedex 09 (FR)**

(56) Documents cités:
**US-A- 5 285 155     US-A1- 2011 065 585
US-B1- 6 285 186     US-B1- 6 690 162**

**Description**

L'invention a pour domaine celui des capteurs magnétométriques, et plus particulièrement celui des capteurs magnétométriques différentiels pour la mesure de champs magnétiques alternatifs ou, plus généralement, de champs magnétiques qui varient au cours du temps.

Un capteur magnétométrique comporte un composant sensible au champ magnétique, dénommé senseur magnétique dans le présent document, qui est propre à délivrer, sous la forme d'une tension ou d'un courant, un signal de mesure correspondant au champ magnétique externe $B_{ext}$ dans lequel il est plongé.

Les capteurs magnétométriques actuels possèdent une plage d'utilisation en fréquence, ou bande passante, limitée. Ceci est dû à l'impédance du circuit de mesure placé en aval du senseur magnétique.

L'élargissement de la bande passante des capteurs magnétométriques est un problème général de ce domaine technique. Pour contourner ce problème, on considère que la zone utile d'un capteur magnétométrique est par principe limitée et on cherche simplement à optimiser sa bande passante en jouant sur la valeur de l'impédance du circuit de mesure.

Par ailleurs, les senseurs magnétiques connus possèdent un signal de réponse qui n'est pas linéaire avec le champ magnétique à mesurer.

Parmi les senseurs magnétiques, on connait les senseurs magnétiques optiques, tels que les senseurs à centres N-V diamant, dans lesquels la transition entre deux niveaux énergétiques des électrons d'un atome constituant une impureté dans un cristal est modifiée lorsque ce cristal est plongé dans un champ magnétique externe $B_{ext}$. La modification de la transition modifie la réponse du cristal éclairé par une lumière laser adapté. Un tel senseur magnétique fonctionne à température ambiante.

La réponse du cristal est linéaire mais sur une plage de fréquences réduite autour d'une fréquence caractéristique de la transition utilisée.

Parmi les senseurs magnétiques, on connait également les senseurs magnétiques supraconducteurs, qui sont particulièrement intéressants, puisqu'ils offrent les plus hautes sensibilités physiquement atteignables. Un tel senseur magnétique, mettant en oeuvre des matériaux supraconducteur, fonctionne à des températures basses, autour de 80 K environ, pour les matériaux supraconducteurs dits à haute température critique, ou ultra-basses, autour du milli-Kelvin environ pour les matériaux supraconducteurs dits à basse température critique.

Un senseur magnétique supraconducteur est un composant SQUID (« Superconducting QUantumInterference Device » en anglais) ou un composant SQIF (« Superconducting Quantum Interference Filter » en anglais). Un composant SQIF est constitué d'une matrice de composants SQUID, connectés en série, en parallèle ou les deux.

Du fait de leurs principes de fonctionnement, les composants SQUID et SQIF ont une réponse non linéaire, c'est-à-dire que la tension $V(\phi)$ induite par le flux $\phi$ du champ magnétique externe $B_{ext}$ traversant une surface S du composant, n'est pas une fonction linéaire du flux $\phi_{ext}$, et par conséquent du champ magnétique externe $B_{ext}$.

Dans le cas d'un composant SQUID, cette réponse est sinusoïdale. Dans la région du point d'inflexion de la sinusoïde, le comportement est, au premier ordre, linéaire. Cependant, cette région correspond à une plage de flux relativement étroite.

Dans le cas d'un composant SQIF, la réponse est uniforme, $V(\phi)$ = cste, sauf autour de certains points caractéristiques, disposés périodiquement, pour lesquels le flux $\phi_{ext}$ du champ magnétique externe $B_{ext}$ est égal à un nombre entier de fois un flux caractéristique $\phi_0$, dit « fluxon ». Ainsi, la réponse d'un composant SQIF prend la forme d'un « peigne inversé ».

Dans un composant SQIF modifié, présentant une configuration particulière, la réponse est uniforme sauf dans une région autour de l'origine, $\phi_{ext}$ = 0, où cette réponse s'annule. Dans cette région, la réponse, symétrique autour de l'origine, est quasi-linéaire. Cependant, cette région correspond à une plage de flux relativement étroite.

Pour exploiter la sensibilité d'un senseur magnétique supraconducteur, il faut se placer dans le domaine linéaire, qui est cependant réduit à des régions étroites.

Ainsi, même si les senseurs magnétiques sont très sensibles, leur défaut principal reste donc leur très faible bande passante.

On connaît, par les documents US 6690 162 B1 et US 2011/065585A1, un capteur magnétométrique comportant un senseur magnétique ayant une surface et générant un signal de réponse lorsqu'il est plongé dans un champ magnétique externe créant un flux externe à travers ladite surface, le capteur magnétométrique comportant : un circuit de contrôle prenant en entrée le signal de réponse du senseur magnétique et générant en sortie un courant de contre réaction ; et un fil conducteur disposé au voisinage du senseur magnétique et connecté en sortie du circuit de contrôle, le fil étant traversé par le courant de contre réaction, le circuit et le fil conducteur étant tels qu'un champ magnétique de contre réaction est créé dont le flux de contre réaction à travers la surface du senseur magnétique compense substantiellement, à chaque instant, le flux externe, un signal de sortie du capteur magnétométrique étant constitué par le courant de contre réaction.

Le document US 5 285 155 A décrit en outre que le signal de sortie du capteur magnétométrique constitue une mesure linéaire du champ magnétique externe.

L'invention a donc pour but de pallier ces problèmes.

L'invention est notamment relative à un capteur magnétométrique conforme aux revendications.

L'invention et ses avantages seront mieux compris à la lecture de la description qui va suivre de modes de réalisation et d'utilisation, donnés uniquement à titre d'exemple, et faite en se référant aux dessins annexés sur lesquels :

- La figure 1 est une représentation de principe d'un capteur magnétométrique ;
- La figure 2 est une représentation schématique du capteur de la figure 1 ; et,
- La figure 3 est une représentation schématique d'un mode de réalisation dit en méandres du capteur de la figure 1, mode de réalisation constituant l'invention ;

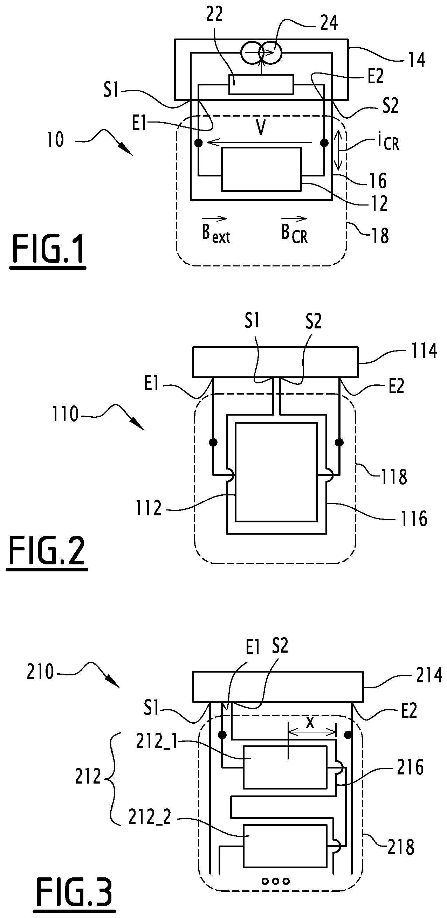

Un capteur magnétométrique est représenté sur la figure 1.

Il a pour fonction de permettre une mesure instantanée d'un champ magnétique externe $B_{ext}(t)$, qui varie au cours du temps t.

Le capteur magnétométrique 10 comporte un senseur magnétique 12, un circuit de contrôle 14 et un fil conducteur 16.

Avantageusement, le capteur magnétométrique 10 comporte un boîtier délimitant intérieurement une cavité dans laquelle sont logés au moins le senseur magnétique 12 et le fil conducteur 16, et éventuellement le circuit de contrôle 14. La cavité, référencée de manière générale par le chiffre 18 sur la figure 1, correspond au volume dans lequel règne le champ magnétique à mesurer, ce volume étant isolé, par le boitier de toute autre influence ou perturbation magnétique parasite. Le matériau dont est constitué le boîtier est donc adapté pour isoler la cavité des champs magnétiques parasites.

Le senseur magnétique 12 est de préférence un senseur magnétique supraconducteur.

Le senseur magnétique 12 est de forme parallélépipédique rectangle. Il présente une faible épaisseur et une surface active S, sensiblement plane et présentant une normale dans le sens de l'épaisseur du senseur magnétique.

Le senseur magnétique 12 est propre à générer, entre ses deux bornes de sortie, un signal de réponse, qui est ici une tension V. La tension V est une fonction du flux magnétique total instantané $\phi(t)$ à travers la surface S.

Le circuit de contrôle 14 reçoit entre ses deux bornes d'entrée E1 et E2 le signal de réponse $V(\phi(t))$ produit par le senseur magnétique 12, et génère un courant de contre réaction $i_{CR}(t)$ entre ses deux bornes de sortie S1 et S2.

Plus précisément, le circuit de contrôle 14 comporte un moyen de comparaison 22 comportant deux bornes d'entrée, connectées aux bornes de sortie du senseur magnétique 12, et propre à comparer le signal de réponse $V(\phi(t))$ à un signal de référence $V_0$ et à générer un signal de comparaison.

Le circuit de contrôle 14 comporte une source de courant 24 commandée par le signal de comparaison et propre à générer, entre deux bornes de sortie, le courant de contre réaction $i_{CR}(t)$.

Le fil conducteur 16 est connecté entre les bornes de sortie du circuit de contrôle 14. Il est conformé pour circuler au voisinage du senseur magnétique 12. Le fil conducteur 16 est traversé par le courant de contre réaction $i_{CR}(t)$. De ce fait il crée autour de lui un champ magnétique de contre réaction $B_{CR}(t)$. Le champ $B_{CR}(t)$ est linéaire par rapport au courant $i_{CR}(t)$. Il crée un flux de contre réaction $\phi_{CR}(t)$ à travers la surface S du senseur magnétique : $\phi_{CR}(t) = B_{CR}(t).S$

A chaque instant, le signal de réponse V(t) que délivre le senseur magnétique 12 dépend du flux magnétique total $\phi(t)$ traversant la surface S.

Ce flux total $\phi(t)$ est la somme d'un flux externe $\phi_{ext}(t)$, qui résulte du champ magnétique externe $B_{ext}(t)$ à mesurer selon la relation $\phi_{ext}(t) = B_{ext}(t).S$, et du flux de contre réaction $\phi_{CR}(t)$.

Le capteur 10 est à l'équilibre lorsque le flux total $\phi(t)$ reçu par le senseur magnétique 12 est constant. Dans ce régime, forcé en permanence par la contre réaction instantanée, le courant de contre réaction $i_{CR}(t)$ représente une mesure linéaire du champ magnétique externe $B_{ext}(t)$

Pour que cet équilibre existe, les paramètres géométriques et physiques du capteur 10 sont choisis de telle sorte que le flux de contre réaction soit opposé au flux externe et que la réponse V(t) du senseur magnétique 12 puisse être instantanément ramenée au niveau de la tension de référence $V_0$. Dit autrement, le circuit de contrôle 14 et le fil conducteur 16 sont tels qu'un champ magnétique de contre réaction est créé, dont le flux à travers la surface active du senseur magnétique compense substantiellement, à chaque instant, le flux du champ magnétique externe.

Il est à noter que si le champ magnétique externe $B_{ext}$ possède une composante continue, le point de stabilisation sera la tension de référence $V_0$ décalée d'une constante. Cette constante peut être annulée par le courant de contre réaction $i_{CR}$, en appliquant un biais sur la tension de référence $V_0$.

Par le choix adapté de la tension de référence $V_0$, la sensibilité maximale du capteur 10 est obtenue pour la zone de réponse du senseur magnétique où la dérivée $\dfrac{\partial V}{\partial \phi}$ est maximale.

Il est à souligner que dans le capteur magnétométrique 10, le signal de réponse du senseur magnétique n'est pas considéré comme un signal de mesure, mais comme un signal de régulation d'une boucle de contre réaction. C'est le signal de contre réaction qui constitue le signal de mesure.

A la figure 2 est représenté un capteur 110 dans lequel le fil conducteur 116 est configuré de manière à former une boucle autour du senseur magnétique 112.

Le fil 116 se situe sensiblement dans le plan P de la surface S du senseur magnétique 112.

La boucle peut comporter N spires, ce qui permet d'augmenter le flux de contre réaction pour une même amplitude du courant de contre réaction.

Cette configuration en boucle présente une réponse large-bande.

La bande passante est limitée aux fréquences hautes principalement par un effet de résistance radiative, $R_{rad}$, qui est proportionnelle à $f^4$, où f est la fréquence du courant de contre réaction $i_{CR}$. La résistance radiative domine ici sur une autre limitation qui est due à l'inductance de la boucle formée par le fil 116, cette inductance étant proportionnelle à f.

En diminuant les dimensions du circuit formé par le fil conducteur 116, la résistance radiative $R_{rad}$ peut être réduite de façon à repousser au maximum la fréquence de coupure haute du capteur 110.

Cette configuration en boucle autorise une intégration dense à une ou deux dimensions dans le plan P.

Cette configuration en boucle permet la réalisation d'un capteur magnétique aux dimensions réduites.

A la figure 3 est représenté un capteur 210 qui constitue un mode de réalisation préféré du capteur présenté à la figure 1 de manière générique.

Dans ce second mode de réalisation, dite configuration en méandres, le senseur magnétique 212 est constitué d'une pluralité de senseur magnétiques élémentaires 212-i, qui sont disposés selon une rangée, de manière à ce que leurs surfaces Si soient dans le même plan P, et qui sont connectés en série entre les bornes d'entrée E1 et E2 du circuit de contrôle 14.

Le fil conducteur 216 est configuré de manière à circuler entre deux senseurs magnétiques élémentaires 212-i de manière à former une pluralité de méandres. Les senseurs élémentaires 212-i sont placés dans un méandre sur deux pour que le flux du champ magnétique de contre-réaction créé par le fil 216 ait toujours le même signe et puisse compenser le champ magnétique externe à mesurer.

Dans ce mode de réalisation, les senseurs magnétiques élémentaires 212-i sont asymétriques (leur réponse étant telle que : $v(-\phi) = -V(\phi)$), ou symétriques (leur réponse étant telle que : $v(-\phi) = v(\phi)$).

La configuration en méandres est caractérisée par une inductance et une résistance radiative qui sont intrinsèquement plus faibles que celle de la configuration en boucle, ce qui permet de repousser davantage la fréquence de coupure haute de la bande passante du capteur 210.

Là encore, par le choix de très petites dimensions pour le circuit formé par le fil 216, la résistance radiative peut être réduite de façon à repousser au maximum la fréquence de coupure haute du capteur.

De plus, il est possible d'optimiser les paramètres géométriques. Par exemple, la distance x entre le fil 216 et l'axe des senseurs magnétiques peut être augmentée. Le champ magnétique créé par un fil diminuant en 1/x, pour obtenir le même flux de contre réaction il faut augmenter le courant de contre réaction. Ceci présente l'avantage de permettre la détection de champs magnétiques externes de très faible amplitude (selon la normale à la surface Si des senseurs magnétiques), grâce à l'utilisation de courant de contre réaction d'intensité élevée.

Cette configuration en méandres autorise une intégration dense à une ou deux dimensions dans le plan P. En effet, en utilisant des senseurs magnétiques élémentaires symétriques (tels que par exemple des senseurs magnétiques supraconducteurs du type SQIF), dont la réponse est indépendante du sens du champ magnétique, il est possible de placer des senseurs magnétiques élémentaires 212-i dans chacun des méandres définis par le fil 216. La densité surfacique de senseurs magnétiques élémentaires peut ainsi être augmentée, ce qui, à surface constante du composant, permet d'augmenter la sensibilité du magnétomètre de celui-ci.

Cette configuration en boucle permet la réalisation d'un capteur magnétique aux dimensions réduites.

La configuration en méandres est d'ailleurs plus avantageuse que la configuration en boucle, car plus simple à optimiser et à intégrer à grande échelle.

Le capteur magnétométrique présenté ci-dessus possède une large bande passante sur laquelle, lorsque le senseur magnétique est du type supraconducteur, il possède une très haute sensibilité magnétométrique. Par une conception appropriée du capteur magnétométrique, il est possible d'envisager une bande passante s'étalant de la très basse fréquence VLF (« Very Low Frequency » en anglais), à l'ultra-haute fréquence UHF (« Ultra High Fraquency » en anglais), c'est-à-dire entre environ quelques kHz et environ 1 000 MHz.

Le capteur magnétométrique présenté ci-dessus présente également une réponse linéaire par rapport à l'amplitude du champ magnétique externe à mesurer, qui est uniforme sur toute la bande passante.

En termes d'intensité du champ magnétique externe mesurable, le capteur magnétométrique peut être adapté : segmentation en domaines de courant de contre réaction du circuit de contrôle, dimensionnement optimisé du circuit en boucle/méandres, intégration multi-échelle, etc.

Eventuellement, des filtres passe-bas peuvent être introduits dans le circuit de contrôle, pour permettre de spécifier un certain nombre de plages d'utilisation en fréquence, soit par ordre de grandeur fréquentiel du champ magnétique externe à mesurer, soit par domaines fréquentiels d'intérêt.

Le capteur magnétométrique offre enfin la possibilité d'une intégration planaire haute-densité.

## Revendications

1. Capteur magnétométrique (210) comportant un senseur magnétique (212) ayant une surface (S) et générant un signal de réponse (V) lorsqu'il est plongé dans un champ magnétique externe ($B_{ext}$) créant un flux externe à travers ladite surface, le capteur magnétométrique comportant :

   - un circuit de contrôle (214) prenant en entrée le signal de réponse du senseur magnétique et générant en sortie un courant de contre réaction ($i_{CR}$) ; et,
   - un fil conducteur (216) disposé au voisinage du senseur magnétique (212) et connecté en sortie du circuit de contrôle (214), le fil étant traversé par le courant de contre réaction,

   le circuit et le fil conducteur étant tels qu'un champ magnétique de contre réaction ($B_{CR}$) est créé dont le flux de contre réaction à travers la surface du senseur magnétique (212) compense substantiellement, à chaque instant, le flux externe, un signal de sortie du capteur magnétométrique étant constitué par le courant de contre réaction, le signal de sortie du capteur magnétométrique constituant une mesure linéaire du champ magnétique externe ($B_{ext}$), **caractérisé en ce que** le senseur magnétique (212) est constitué d'une pluralité de senseurs magnétiques élémentaires (212-i) connectés en série entre deux bornes d'entrée du circuit de contrôle (214), et **en ce que** le fil conducteur (216) est configuré pour former au moins un méandre entre deux magnétomètres élémentaires (212-i) voisins.

2. Capteur magnétométrique (210) selon la revendication 1, dans lequel le magnétomètre (12) est un magnétomètre supraconducteur.

3. Capteur magnétométrique (210) selon la revendication 1 ou la revendication 2, dans lequel le champ magnétique externe ($B_{ext}$) étant variable au cours du temps, le signal de sortie du capteur magnétométrique (210) constitue une mesure du champ magnétique externe.

4. Capteur magnétométrique (210) selon l'une quelconque des revendications précédentes, dans lequel la surface du senseur magnétique est plane et dans lequel le fil conducteur est placé sensiblement dans le plan de ladite surface.

5. Capteur magnétométrique (210) selon l'une quelconque des revendications précédentes, dans lequel le circuit de contrôle (214) comporte un moyen (22) de comparaison du signal de réponse (V) du senseur magnétique (212) par rapport à un signal de référence ($V_0$) propre à générer un signal de comparaison, et une source de courant (24) commandée par le signal de comparaison et propre à générer le courant de contre réaction ($i_{CR}$).

6. Capteur magnétométrique (210) selon l'une quelconque des revendications précédentes, dans lequel le fil conducteur (216) est configuré pour former au moins une boucle.

7. Capteur magnétométrique (210) selon la revendication 6, dans lequel la boucle comporte une pluralité de spires (N).

8. Capteur magnétométrique (210) selon l'une quelconque des revendications précédentes, comportant un boîtier délimitant une cavité (218) isolée des perturbations magnétiques parasites et à l'intérieur de laquelle est logé le senseur magnétique et le fil conducteur.

## Patentansprüche

1. Magnetometrischer Sensor (210), welcher einen Magnetsensor (212) aufweist, der eine Fläche (S) hat und ein Antwortsignal (V) erzeugt, wenn er in ein äußeres Magnetfeld ($B_{ext}$) getaucht wird, welches einen äußeren Fluss quer zu der besagten Fläche erzeugt, wobei der magnetometrische Sensor aufweist:

   - einen Steuerschaltkreis (214), der am Eingang das Antwortsignal des Magnetsensors annimmt und am Ausgang einen Rückkopplungs-Strom ($i_{CR}$) erzeugt, und
   - einen Leitungsdraht (216), der benachbart zu dem Magnetsensor (212) angeordnet ist und mit dem Ausgang des Steuerschaltkreises (214) verbunden ist, wobei der Draht von dem Rückkopplungs-Strom durchlaufen wird,

   wobei der Schaltkreis und der Leitungsdraht derart sind, dass ein Rückkopplungs-Magnetfeld ($B_{CR}$) erzeugt wird, von welchem der Rückkopplungs-Fluss quer zu der Fläche des Magnetsensors (212) im Wesentlichen zu jeder Zeit den äußeren Fluss kompensiert, wobei ein Ausgangssignal des magnetometrischen Sensors mittels des Rückkopplungs-Stroms gebildet wird, wobei das Ausgangssignal des magnetometrischen Sensors ein Maß bildet, welches linear zu dem äußeren Magnetfeld ($B_{ext}$) ist, **dadurch gekennzeichnet, dass** der Magnetsensor (212) von einer Mehrzahl von elementaren Magnetsensoren (212-i) gebildet ist, die zwischen zwei Eingangs-Anschlussklemmen des Steuerschaltkreises (214) in Reihe verbunden sind, und dadurch, dass der Leitungsdraht (216) eingerichtet ist, um mindestens eine Windung zwischen zwei benachbarten elementaren Magnetometern (212-i) zu bilden.

2. Magnetometrischer Sensor (210) gemäß Anspruch 1, wobei das Magnetometer (12) ein Supraleitungs-Magnetometer ist.

3. Magnetometrischer Sensor (210) gemäß Anspruch 1 oder Anspruch 2, wobei, wenn das äußere Magnetfeld ($B_{ext}$) im Lauf der Zeit variabel ist, das Ausgangssignal des magnetometrischen Sensors (210) ein Maß des äußeren Magnetfeldes bildet.

4. Magnetometrischer Sensor (210) gemäß irgendeinem der vorherigen Ansprüche, wobei die Fläche des Magnetsensors eben ist, und wobei der Leitungsdraht im Wesentlichen in der Ebene der besagten Fläche angeordnet ist.

5. Magnetometrischer Sensor (210) gemäß irgendeinem der vorherigen Ansprüche, wobei der Steuerschaltkreis (214) aufweist ein Mittel (22) zum Vergleich des Antwortsignals (V) des Magnetsensors (212) bezüglich eines Referenzsignals ($V_0$), welches imstande ist, ein Vergleichssignal zu erzeugen, und eine Stromquelle (24), die mittels des Vergleichssignals gesteuert wird und imstande ist, den Rückkopplungs-Strom ($i_{CR}$) zu erzeugen.

6. Magnetometrischer Sensor (210) gemäß irgendeinem der vorherigen Ansprüche, wobei der Leitungsdraht (216) eingerichtet ist, um mindestens eine Schlaufe zu bilden.

7. Magnetometrischer Sensor (210) gemäß Anspruch 6, wobei die Schlaufe eine Mehrzahl an Windungen (N) aufweist.

8. Magnetometrischer Sensor (210) gemäß irgendeinem der vorherigen Ansprüche, welcher ein Gehäuse aufweist, welches eine Kavität (218) begrenzt, die von parasitären magnetischen Störungen isoliert ist und im Innenraum von welcher der Magnetsensor und der Leitungsdraht untergebracht sind.

## Claims

1. A magnetometric sensor (210) including a magnetic sensor (212) having a surface (S) and generating a response signal (V) when it is immersed in an external magnetic field ($B_{ext}$) which generates an external flux through said surface, the magnetometric sensor including:

   - a control circuit (214) taking at an input the response signal of the magnetic sensor and generating at an output a feedback current ($i_{CR}$); and,
   - a conductive wire (216) positioned in a vicinity of the magnetic sensor (212) and connected to the output of the control circuit (214), the conductive wire being crossed by the feedback current,

the control circuit and the conductive wire being such that a feedback magnetic field ($B_{CR}$) is generated, a feedback flux thereof through the surface of the magnetic sensor (212) substantially compensates at each instant for the external flux,
an output signal of the magnetometric sensor being formed by the feedback current,
the output signal of the magnetometric sensor is a linear measure of the external magnetic field ($B_{ext}$), **characterized in that** the magnetic sensor (212) is made of a plurality of elementary magnetic sensors (212-i) connected in series between two input terminals of the control circuit (214), and **in that** the conductive wire (216) is configured in order to form at least one meander between two neighboring elementary magnetic sensors (212-i).

2. The magnetometric sensor (210) according to claim 1, wherein the magnetic sensor (12) is a superconducting magnetometer.

3. The magnetometric sensor (210) according to claim 1 or claim 2, wherein the external magnetic field ($B_{ext}$) being variable overtime, the output signal of the magnetometric sensor (10) is a measurement of the external magnetic field.

4. The magnetometric sensor (210) according to any of the preceding claims, wherein the surface of the magnetic sensor is planar and wherein the conductive wire is placed substantially in the plane of said surface.

5. The magnetometric sensor (210) according to any of the preceding claims, wherein the control circuit (e14) includes a comparison means (22) comparing the response signal (V) of the magnetic sensor (212) relatively to a reference signal ($V_0$) and generating a comparison signal, and a current source (24) controlled by the comparison signal and generating the feedback current ($i_{CR}$).

6. The magnetometric sensor (210) according to any of the preceding claims, wherein the conductive wire (216) is configured for forming at least one loop.

7. The magnetometric sensor (210) according to claim 6, wherein the loop includes a plurality of turns (N).

8. The magnetometric sensor (210) according to any of the preceding claims, including a case delimiting a cavity (218) isolated from parasitic magnetic perturbations and inside which is housed the magnetic sensor and the conductive wire.

## FIG.1

## FIG.2

## FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6690162 B1
- US 2011065585 A1
- US 5285155 A